Europäisches Patentamt

European Patent Office

Office européen des brevets

(11) Veröffentlichungsnummer: **0 299 204 B1**

# (12) EUROPÄISCHE PATENTSCHRIFT

(45) Veröffentlichungstag der Patentschrift: **04.11.92**

(21) Anmeldenummer: **88109258.9**

(22) Anmeldetag: **10.06.88**

(51) Int. Cl.⁵: **G01D 5/251**, G06K 11/16

(54) **Manuell zu betätigender Positionsgeber.**

(30) Priorität: **10.07.87 DE 3722890**

(43) Veröffentlichungstag der Anmeldung:
**18.01.89 Patentblatt 89/03**

(45) Bekanntmachung des Hinweises auf die
Patenterteilung:
**04.11.92 Patentblatt 92/45**

(84) Benannte Vertragsstaaten:
**AT BE CH FR GB GR IT LI NL SE**

(56) Entgegenhaltungen:
**GB-A- 2 026 745**
**US-A- 4 129 747**

**COMPUTER DESIGN, Band 20, Nr. 11, November 1981, Seiten 137,138,140, Winchester, MA, US; R.A. ABLER: "Touch pad control for the harsh environment"**

**PATENT ABSTRACTS OF JAPAN, Band 378, Nr. 11 (P-645), 10. Dezember 1987; & JP-A-62 148 801**

(73) Patentinhaber: **Euchner & Co.**
**Kohlhammerstrasse 16**
**W-7022 Leinfelden-Echterdingen(DE)**

(72) Erfinder: **Rapp, Werner, Dipl.-Ing.**
**Südmährer Strasse 26**
**W-7340 Geislingen(DE)**
Erfinder: **Link, Walter, Dr.-Ing.**
**Beethovenstrasse 13**
**W-7255 Rutesheim(DE)**
Erfinder: **Ouinzio, Giovanni, Dipl.-Ing.**
**Eisbärenstrasse 18**
**W-7000 Stuttgart-80(DE)**

(74) Vertreter: **Patentanwälte Phys. Bartels**
**Dipl.-Ing. Fink Dr.-Ing. Held**
**Lange Strasse 51**
**W-7000 Stuttgart 1(DE)**

**Beschreibung**

Die Erfindung betrifft einen manuell zu betätigenden Positionsgeber mit elektrischen Ausgangssignalen, der die Merkmale des Oberbegriffes des Anspruches 1 aufweist.

Außer Positionsgebern, die eine mittels eines Drehknopfes verstellbare, drehbare Scheibe aufweisen, welche nur mit einer Taktspur, nur mit einer die absolute Position angebenden Kodierung oder mit beiden Kennzeichnungen versehen ist, welche optisch abgetastet werden, und den unter der Bezeichnung "Maus" bekannten Positionsgebern, die in einem von Hand bewegbaren Gehäuse zwei Impulsgeber aufweisen, die zwei rechtwinklig zueinander verlaufenden Bewegungsrichtungen zugeordnet sind und pro zurückgelegter Wegeinheit eine bestimmte Anzahl von Impulsen abgeben, sind auch Positionsgeber der eingangs genannten Art bekannt (GB-A-2 026 745). Diese Positionsgeber weisen auf der einen Seite einer elektrisch isolierenden Platte eine erste Gruppe von in Zeilen und Spalten angeordneten Elektroden auf und jede dieser Elektroden überdeckt eine auf der anderen Seite der Platte angeordnete Elektrode einer zweiten Gruppe, die zeilenweise mit einer Signalausweschaltung verbunden sind. Die Elektroden der ersten Gruppe sind hingegen spaltenweise mit einer Spannungsquelle verbunden, welche nacheinander an jede Spalte ein Abtastsignal anlegt. Die Elektroden der ersten Gruppe werden von einer elektrisch isolierenden Schicht bedeckt, deren den Elektroden abgekehrte Seite als Auflagefläche für einen Finger des Benutzers vorgesehen ist. Ein als Signalausweschalter vorgesehener Mikroprozessor ermittelt die Zeile und Spalte, in welcher diejenige Elektrode der ersten Gruppe liegt, auf die der Finger des Benutzers ausgerichtet ist.

Bei einem anderen bekannten Positionsgeber (Computer Design, Band 20, (1981), Nov., Nr. 11, Seite 137, 138 und 140) sind ebenfalls kapazitive Sensoren vorgesehen, die bei einer Berührung mittels eines Fingers vom logischen Zustand Null in den logischen Zustand Eins wechseln und auf einer Leiterplatte vollständig abgedeckt in rechtwinklig zueinander verlaufende Zeilen und Spalten ergebenden Reihen angeordnet sind. Die von diesen Sensoren angesteuerte elektronische Schaltung setzt die von den Sensoren gelieferten Signale in kodierte Signale um und ermöglicht nicht nur die Ermittlung der Position des augenblicklich berührten Sensors, sondern auch die Bewegung und Richtung eines über die Oberfläche des Positionsgebers gleitenden Fingers. Deshalb werden mit hoher Taktfrequenz alle Sensoren abgefragt und das sich dabei ergebende Muster in einem Register gespeichert. Dort erfolgt ein Vergleich mit dem bei der vorausgehenden Abfrage erhaltenen Muster, das ebenfalls in einem Register gespeichert ist.

Der Erfindung liegt die Aufgabe zugrunde, einen Positionsgeber der eingangs genannten Art dahingehend zu verbessern, daß die Positionserfassung in einfacher Weise möglich ist. Diese Aufgabe löst ein Positionsgeber mit den Merkmalen des Anspruches 1.

Die Wirkung des erfindungsgemäßen Positionsgebers beruht auf der Veränderung der kapazitiven Kopplung zwischen den mit dem Finger des Benutzers wenigstens teilweise überdeckten Elektroden sowie der Änderung der kapazitiven Belastung gegenüber Erde. Für die Positionsermittlung genügt daher ein Vergleich der von den Elektroden gelieferten Signale.

Bewegbare Teile weist der erfindungsgemäße Positionsgeber ebenso wie die bekannten Positionsgeber der eingangs genannten Art nicht auf. Da die Elektroden durch eine isolierende Schicht bedeckt sind, bereitet es keine Schwierigkeiten, sie vor Korrosion zu schützen. Eine Verschmutzung, insbesondere eine Schmutzablagerung auf der Auflagefläche für den Finger, ist nicht störend, da durch sie allenfalls die Absolutwerte der kapazitiven Kopplung und der kapazitiven Belastung verändert werden, was jedoch die Funktionsweise nicht beeinträchtigt. Außerdem läßt sich die Auflagefläche einfach reinigen.

Bei einer bevorzugten Ausführungsform sind die Elektroden gemäß Anspruch 2 durch Bereiche einer leitenden Schicht einer elektrisch isolierenden Platte gebildet. Da diese Bereiche wie die Leiterbahnen einer Platine hergestellt werden können, lassen sich nicht nur geradlinige, parallele Streifen, sondern auch komplizierte Formen kostengünstig realisieren.

Sind die Elektroden in einer einzigen Reihe angeordnet, dann genügt für die Auswertung der Signale ein Differenzverstärker. Sind die Elektroden in einer Matrix angeordnet, wird der Aufwand für die Signalauswertung nur verdoppelt. In der Regel genügen deshalb für jede Koordinate zwei Differenzverstärker mit nachgeschalteter Richtungslogik.

Der Vergleich der Signale erfolgt vorteilhafterweise bei einer Elektrodenanordnung gemäß Anspruch 3 mittels eines Differenzverstärkers. Genügt für die Positionsbestimmung die Kenntnis, ob die Elektrode der zweiten oder diejenige der dritten Gruppe ein größeres Signal liefert, dann kann die Position aus der Phasenlage der Ausgangsspannung des Differenzverstärkers gegenüber der Spannung der Elektrode der ersten Gruppe ermittelt werden. Zusätzlich zu einer solchen Ortsgrobauflösung kann man eine Ortsfeinauflösung zwischen zwei benachbarten Elektroden durch einen Vergleich der Amplituden der Signale erhalten, weil die Amplitude der Ausgangsspannung des Differenzverstärkers kontinuierlich mit einer Verschiebung des Fingers von der auf die Elektrode der ersten Gruppe ausgerichteten Mittellage gegen die Elektrode der zweiten oder der dritten Gruppe hin zunimmt. Schließlich ist, wenn mehrere Elektroden der ersten Gruppe so wie zu beiden Seiten derselben angeordnete Elektroden der zweiten und dritten Gruppe vorhanden sind, auch eine absolute Positionsbestimmung möglich. Hierzu brauchen nur die Ausgangsspannungen der Differenzverstärker miteinander verglichen zu werden, wozu eine einfache Schaltung genügt, welche außer einer Vergleichseinrichtung noch je einen Spitzenwertgleichrichter für jedes aus einer Elektrode der zweiten und dritten Gruppe bestehendes Elektrodenpaar aufweist. Für einen Einsatz als inkrementalen Positionsgeber werden die Elektroden gemäß Anspruch 5 angeordnet. Fährt man hierbei mit dem Finger über die nebeneinander angeordneten Elekroden, dann erhält man eine Signalfolge, aufgrund deren mittels einer Richtungslogik die Bewegungsrichtung erkannt werden kann.

Ebenso einfach wie Positionsgeber für eine lineare Bewegung lassen sich auch Positionsgeber für zweidimensionale Bereiche realisieren. Hierzu brauchen nämlich die Elektroden nur in einer Matrix gemäß Anspruch 9 angeordnet zu sein. Der Aufwand für die Signalauswerteschaltung wird gegenüber dem Aufwand für einen linearen Positionsgeber nur verdoppelt. In der Regel genügen deshalb für jede Koordinate zwei Differenzverstärker mit nachgeschalteter Richtungslogik.

Im folgenden ist die Erfindung anhand von in der Zeichnung dargestellten Ausführungsbeispielen im einzelnen erläutert.

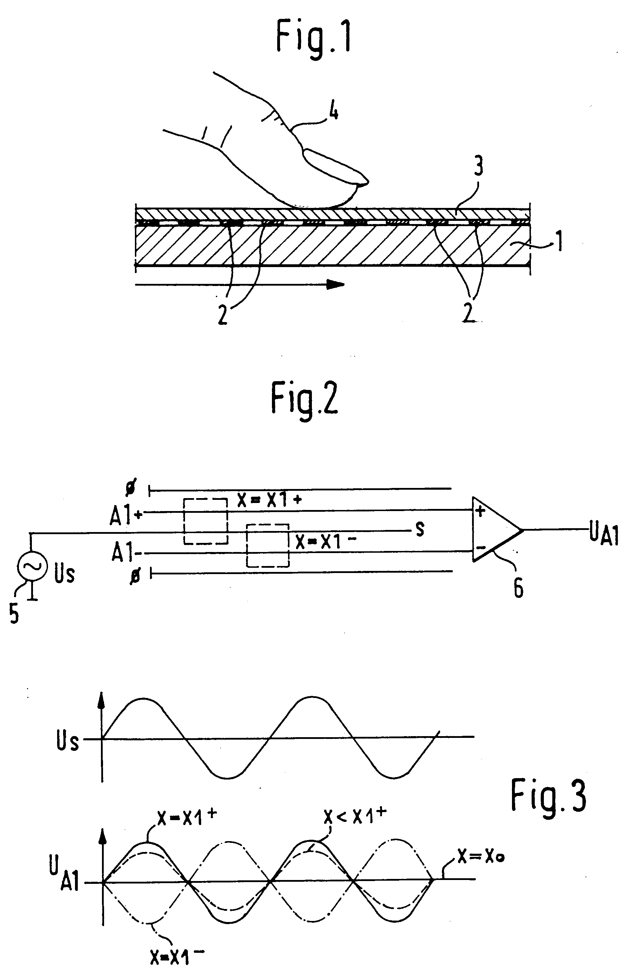

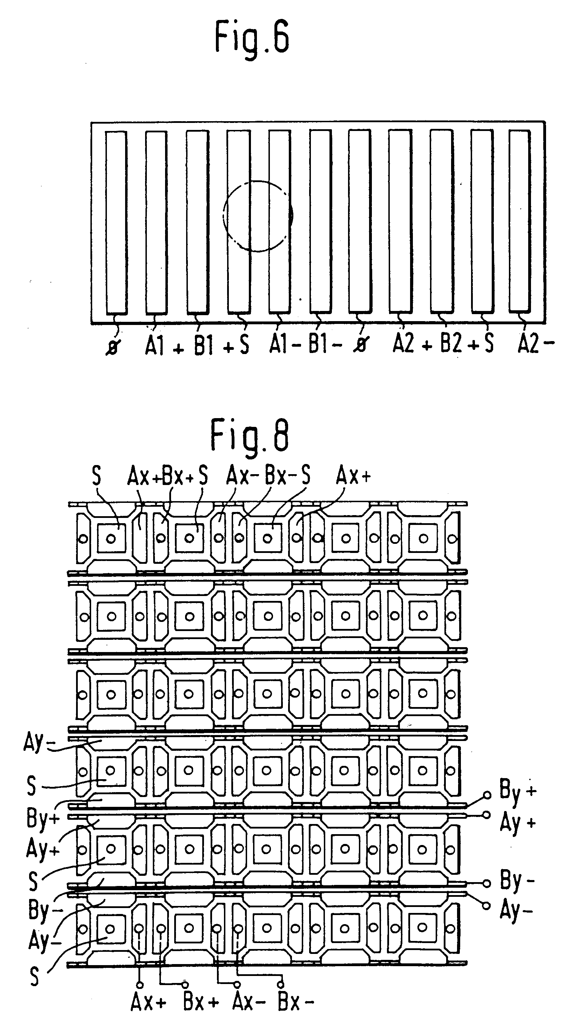

Es zeigen
Fig. 1
einen Längsschnitt durch ein erstes Ausführungsbeispiel,
Fig. 2
eine schematisch dargestellte Draufsicht auf einen Ausschnitt des ersten Ausführungsbeispiels,
Fig. 3
die Ausgangsspannung eines Differenzverstärkers in Abhängigkeit von der Speisespannung für die Elektroden und der Position eines Fingers bezüglich dieser Elektroden,
Fig. 4
eine unvollständig dargelltes Schaltbild zu einer Elektrodenanordnung gemäß Fig. 2,

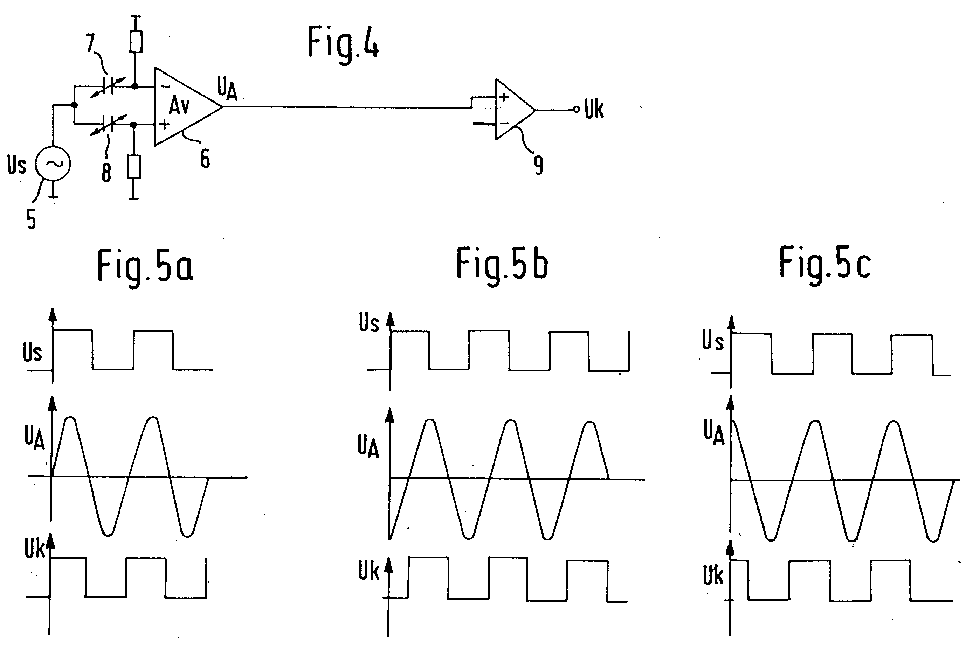

Fig. 5 a bis 5 c
je einen Signalfahrplan zu der Schaltung gemäß Fig. 4 bei unterschiedlichen Fingerpositionen bezüglich der Elektroden,
Fig. 6
eine Darstellung der Elektrodenanordnung bei einem Linear-Positionsgeber,
Fig. 7
ein Schaltbild der Auswerteschaltung für die Elektrodenanordnung gemäß Fig. 6,
Fig. 8
eine Darstellung der Elektrodenanordnung für einen zweidimensionalen Positionsgeber.

Bei dem in Fig. 1 dargestellten Ausführungsbeispiel sind auf einer elektrisch isolierenden Trägerplatte 1, die beispielsweise aus Keramikmaterial oder einem Epoxi-Harz besteht, in einer Reihe nebeneinander Leiterbahnen 2 angeordnet, welche alle die gleiche Form und Größe haben. Auch die Abstände zwischen zwei benachbarten Leiterbahnen 2 sind überall gleich. Auf der Oberseite der als Elektroden dienenden Leiterbahnen 2 liegt eine elektrisch isolierende Folie 3 auf, deren den Leiterbahnen abgekehrte Seite als Auflagefläche für einen Finger 4 der den Positionsgeber bedienenden Person dient.

Wie Fig. 2 zeigt, liegt jeweils eine an eine Spannungsquelle 5, welche die Spannung Us liefert, angeschlossene Elektrode S zwischen einer Elektrode A 1 + und einer Elektrode A 1 -. Auf der der Elektrode S abgekehrten Seite folgt dann auf die beiden Elektroden A 1 + und A 1 - je eine auf O-Potential liegende Elektrode. Die Elektrode A 1 + ist an den positiven Eingang, die Elektrode A 1 - an den negativen Eingang eines Differenzverstärkers 6 angeschlossen.

Wird der Finger 4 mittig auf die Elektrode S aufgelegt, dann ist die kapazitive Koppelung zwischen der Elektrode A 1 + und der Elektrode S genauso groß wie zwischen den Elektroden A 1 - und S. Auch die kapazitive Belastung gegenüber O-Potential ist gleich groß. An den beiden Eingängen des Differenzverstärkers 6 liegen daher gleich große Signale an. Somit ist die Ausgangsspannung $U_{A1}$ für diese Position des Fingers, welche in Fig. 3 mit X = X0 gekennzeichnet ist, gleich O. Bewegt man den Finger von dieser Mittelstellung aus in die in Fig. 2 mit X = X 1 + gekennzeichnete Position, in welcher die kapazitive Koppelung der Elektorde A 1 + mit der Elektrode S erhöht ist, dann erhält man eine im Vergleich zur Spannung Us der Spannungsquelle 5 positive Ausgangsspannung $U_{A1}$. Daher ist in Fig. 3 die zur Spannung Us gleichphasige Spannung $U_{A1}$ mit X = X 1 + gekennzeichnet. Entsprechend erhält man bei einer Fingerposition X = X 1 - eine bezüglich der Spannung Us negative Spannung $U_{A1}$. Diese Spannung ist deshalb in Fig. 3 mit X = X 1 - gekennzeichnet.

Die Amplitude der Ausgangsspannung $U_{A1}$ des Differenzverstärkers 6 hängt von der Fingerposition ab. Ist der Abstand von der Mittelposition kleiner als im Falle X = X 1 +, dann erhält man eine gegenüber der Spannung Us positive Ausgangsspannung mit kleiner Amplitude, wie dies der in Fig. 3 mit X < X 1 + gekennzeichnete Spannungsverlauf zeigt. Während das Vorzeichen der

Ausgangsspannung $U_{A1}$ nur angibt, ob der Finger zur einen oder anderen Seite von der Mittelstellung aus versetzt liegt, was man als eine Ortgrobauflösung bezeichnen kann, läßt sich durch eine Auswertung der Amplitudengröße eine Ortsfeinauflösung realisieren.

Das Ersatzschaltbild der Elektrodenanordnung gemäß Fig. 2 mit der Spannungsquelle 5 und dem Differenzverstärker 6 zeigt Fig. 4. Handelt es sich bei der Spannung Us um eine Rechteckspannung und befindet sich der Finger in der Mittellage, so daß die beiden Kondensatoren 7 und 8 die gleiche Größe haben, dann ist die Ausgangspannung $U_A$ eine mit der Spannung Us gleichphasige Wechselspannung, wie dies Fig. 5 a zeigt. Die Spannung $U_A$ wird beispielsweise mittels eines Komparators 9 in eine gleichphasige Rechteckspannung Uk umgewandelt, um die Spannung Uk möglichst einfach hinsichtlich Phasenlage und Signalpegel mit der Spannung Us vergleichen zu können. Ist die am Minus-Eingang des Differenzverstärkers 6 anliegende Spannung kleiner als die am Plus-Eingang anliegende Spannung, dann erhält man, wie Fig. 5 b zeigt, eine Phasenverschiebung der Ausgangsspannung $U_A$ des Differenzverstärkers 6 gegenüber der Speisespannung Us. Die gleiche Phasenverschiebung hat die Ausgangsspannung Uk des Komparators 9 gegenüber der Speisespannung Us. Die Größe dieser Phasenverschiebung hängt davon ab, wie weit der Finger aus der Mittellage heraus gegen die Elektrode A 1 + hin verschoben ist. Entsprechend führt eine Verschiebung des Fingers aus der Mittellage gegen die Elektrode A 1 - hin zu einer entsprechenden Phasenverschiebung mit entgegengesetztem Vorzeichen. Fig. 5 c zeigt die Verhältnisse für den Fall, daß die am negativen Eingang des Differenzverstärkers 6 anliegende Spannung größer ist als die am positiven Eingang anliegende Spannung.

Eine Ortsgrobauflösung ist hier durch einen einfachen Vergleich des Signalpegels von Uk beispielsweise mit der high-Flanke der Speisespannung Us möglich. Wie Fig. 5 b zeigt, befindet sich zum Zeitpunkt einer high-Flanke der Spannung Us das Signal Uk auf dem low-Potential, wenn der Finger aus der Mittelstellung heraus gegen die Elektrode A 1 + verschoben ist, und, wie Fig. 5 c zeigt, auf seinem high-Potential, wenn der Finger aus der Mittellage heraus gegen die Elektrode A 1 - verschoben ist.

Bei dem in Fig. 6 dargestellten Ausführungsbeispiel, das den in Fig. 1 im Schnitt dargestellten Aufbau hat, handelt es sich um einen Linear-Positionsgeber. Die rechteckförmigen Leiterbahnen bilden sechs Gruppen von Elektroden. Alle Elektroden derselben Gruppe sind leitend miteinander verbunden. Die mit S gekennzeichneten Elektroden bilden eine erste Gruppe, die an eine die Speisespannung führende Spannungsquelle angeschlossen sind. Neben der Elektrode S der ersten Gruppe liegt auf der in Fig. 6 rechts dargestellten Seite eine Elektrode einer zweiten Gruppe, deren Elektroden fortlaufend mit A 1 -, A 2 - , A 3 - usw. bezeichnet werden. Neben jeder Elektrode dieser zweiten Gruppe liegt je eine Elektrode einer vierten Gruppe. Diese sind mit B 1 - usw bezeichnet. In der entgegengesetzten Richtung folgt auf jede Elektrode S der ersten Gruppe eine Elektrode einer fünften Gruppe. Diese sind mit B 1 +, B 2 + usw. gekennzeichnet. Neben jeder Elektrode dieser fünften Gruppe liegt auf der der Elektrode der ersten Gruppe abgekehrten Seite je eine Elektrode einer dritten Gruppe. Diese Elektroden sind mit A 1 +, A 2 + usw.gekennzeichnet. Zwischen jeder Elektrode dieser dritten Gruppe und einer Elektrode der vierten Gruppe ist eine Elektrode einer sechsten Gruppe angeordnet. Diese mit gekennzeichneten Elektroden liegen alle auf O-Potential.

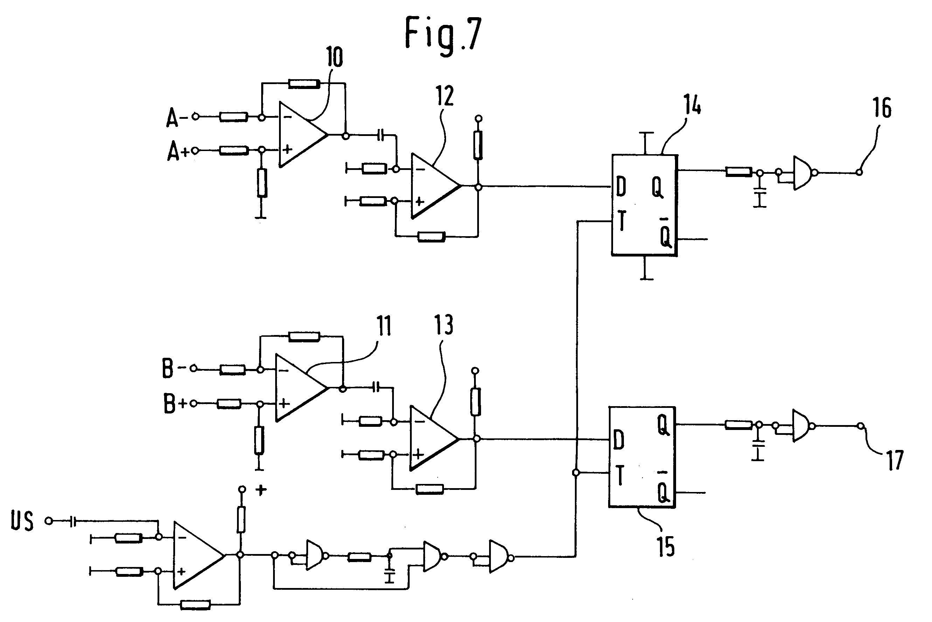

Fig. 7 zeigt die zugehörige Signalauswerteschaltung. Alle Elektroden A 1 - usw. der zweiten Gruppe sind an den Minus-Eingang eines Differenzverstärkers 10, alle Elektroden A 1 +, A 2 + usw. der dritten Gruppe an dessen Plus-Eingang angeschlossen. Entsprechend sind alle Elektroden B 1 - usw. der vierten Gruppe an den Minus-Eingang eines Differenzverstärkers 11 und Elektroden B 1 + usw. der fünften Gruppe an dessen Plus-Eingang angeschlossen. Die Ausgänge der beiden Differenzverstärker 10 und 11 sind kapazitiv an die Minus-Eingänge eines Operationsverstärkers 12 bzw. 13 angeschlossen. Die Ausgangssignale der Operationsverstärker 12 und 13 werden einer Richtunglogik zugeführt, welche im Ausführungsbeispiel zwei D-Flip-Flop 14 und 15 aufweist. Das Ausgangssignal des Operationsverstärkers 12 liegt am D-Eingang des Flip-Flops 14, dasjenige des Operationsverstärkers 13 am D-Eingang des Flip-Flops 15. Am Takt-Eingang T beider Flip-Flops 14 und 15 liegt ein mit Hilfe der Speisespannung Us erzeugtes Taktsignal. Mit Hilfe der Flip-Flops 14 und 15 erfolgt eine Spitzenwert-Abtastung. Die am Ausgang Q auftretenden Signale beider Flip-Flops, die je einer Signalverarbeitungsstufe zugeführt werden, liefern daher an den beiden Ausgängen 16 und 17 der Signalverarbeitungsschaltung zwei Signale, wie sie auch von den bekannten linearen Positionsgebern geliefert werden. Diese beiden Signale werden einem Zähler als Vorwärts-Signale und Rückwärts-Signale zugeführt, so daß der Zählerstand der zu ermittelnden Position entspricht.

Fig. 8 zeigt einen Ausschnitt aus der Elektrodenanordnung eines zweidimensionalen Positionsgebers. Wie bei dem Ausführungsbeispiel gemäß Fig. 1 sind die Elektroden durch leitende Flächenbereiche auf einer elektrisch isolierenden Trägerplatte gebildet. Die Elektroden können deshalb wie die Leiter einer Leiterplatte hergestellt werden. Wie Fig. 8 zeigt, bilden die Elektroden eine Matrix, deren einzelne Reihen alle gleich ausgebildet sind. Von der in Fig. 6 dargestellten Elektrodenfolge unterscheiden sich diese Reihen nur dadurch, daß die bei dem Ausführungsbeispiel gemäß Fig. 6 auf Null-Potential liegende Elektroden ebenfalls an die Speisespannung angeschlossen sind und daher zu der ersten Gruppe gehören, da auf der Rückseite der Trägerplatte eine auf Null-Potential liegede Elektrode vorgesehen ist. Bezeichnet man wie in einem üblichen x/y-Koordinatensystem die in Fig. 8 von links nach rechts verlaufende Richtung als x-Richtung und die von unten nach oben verlaufende Richtung als y-Richtung, dann ergibt sich für die in x-Richtung verlaufenden Reihen die Elektrodenfolge S, Ax +, Bx +, S, Ax-, Bx-, S, Ax +, Bx + usw. In der y-Richtung ist dementsprechend die Elektrodenfolge S, Ay-, By-, S, Ay +, By +, S, Ay- usw. Alle Elektroden S der ersten Gruppe sind über die Rückseite der Trägerplatte miteinander elektrisch leitend verbunden. Dies ist in Fig. 8 durch die in der Elektrodenmitte gezeichneten Kreise dargestellt. Auch bei den übrigen Elektroden bedeuten diese Kreise eine Verbindung über die Rückseite der Trägerplatte. Es sind nämlich auch alle Elektroden A x - miteinander verbunden und an einen entsprechenden Ausgang der Matrix angeschlossen. Entsprechendes gilt für die Elekroden A x +, B x - und B x +. Die Matrix hat daher für die x-Richtung vier Ausgänge. Die in x-Richtung nebeneinander liegenden Elektroden A y- sind auf der Vorderseite miteinander und mit einem gemeinsamen Ausgang verbunden. Entsprechendes gilt für die Elektroden A y +, B y - und B y +. Daher weist die Matrix auch vier Ausgänge für die y-Richtung auf. Eine nicht dargestellte, elektrisch isolierende Folie deckt alle Elektroden ab und dient als Auflagefläche für den Finger.

Die Ausgänge der Matrix für die x-Richtung sind an eine Signalauswerteschaltung angeschlossen, wie sie in Fig. 7 dargestellt ist. An eine zweite, gleich ausgebildete Signalauswerteschaltung sind die Ausgänge der Matrix für die y-Richtung angeschlossen. Eine Bewegung des Fingers über die Matrix führt daher zu Impulsfolgen, die mittel zweier Zähler gezählt werden können. Die beiden Zählerstände geben daher die Fingerposition mit ihrer x-Koordinate und ihrer y-Koordinate wieder. Somit läßt sich mit diesem zweidimensionalen Positionsgeber beispielsweise die gleiche Funktion wie mit dem als "Maus" bekannten Positionsgeber erfüllen.

Alle in der vorstehenden Beschreibung erwähnten sowie auch die nur allein aus der Zeichnung entnehmbaren Merkmale sind weitere Ausgestaltungen der Erfindung, auch wenn sie nicht besonders hervorgehoben sind.

**Patentansprüche**

1. Manuell zu betätigender Positionsgeber mit elektrischen Ausgangssignalen und mit

    a) Gruppen (S, A-, A +, B-, B +) von nebeneinander angeordneten und gegeneinander isolierten Elektroden (S, A 1 -, A 1 +, B 1 -, B 1 +, A x -, A x +, B x -, B x +, A y -, A y +, B y -, B y +), die von einer elektrisch isolierenden Schicht (3) bedeckt sind, deren den Elektroden abgekehrte Seite als Auflagefläche für einen Finger (4) des Benutzers vorgesehen ist,

    b) einer Spannungsquelle (5), an welche alle Elektroden (S) einer ersten Gruppe (S) angeschlossen sind,

    c) einer Signalauswerteschaltung, an welche die Elektroden einer anderen Gruppe (A-, A +, B-, B +) angeschlossen sind,

    dadurch gekennzeichnet, daß

    d) alle Elektroden (S, A 1 -, A 1 +, B 1 +, A x -, A x +, B x -, B x +, A y -, A y +, B y -, B y +) nebeneinander auf der einen Seite der elektrisch isolierenden Schicht (3) angeordnet sind,

    e) die Elektroden (S, A 1 -, A 1 +, B 1 +, A x -, A x +, B x -, B x +, A y -, A y +, B y -, B y +) wenigstens drei Gruppen (S, A-, A +, B-, B +) bilden,

    f) die mit den Elektroden (S) der ersten Gruppe (S) verbundene Spannungsquelle eine Wechselspannung (Us) liefert,

    g) die Elektroden der anderen Gruppen (A-, A +, B-, B +) an die einen Signalvergleich durchführende Signalauswerteschaltung angeschlossen sind und

    h) neben einer Elektrode (S) der ersten Gruppe (S) wenigstens eine Elektrode (A1 +, A1-; A1-, B1 +, A2-, B2 +; Ax +, Bx-, Ax-, Bx +, Ay-, By +, Ay-, By +) der anderen Gruppen (A-, A +, B-, B +) angeordnet ist.

2. Positionsgeber nach Anspruch 1, dadurch gekennzeichnet, daß die Elektroden durch Bereiche einer leitenden Schicht einer elektrisch isolierenden Trägerplatte (1) gebildet sind.

3. Positionsgeber nach Anspruch 1 oder 2, dadurch gekennzeichnet, daß jeweils diejenigen beiden Elektroden einer zweiten und dritten Gruppe, welche den kleinsten Abstand von einer zwischen ihnen angeordneten Elektrode (S) der ersten Gruppe haben, an den einen bzw. anderen Eingang eines Differenzverstärkers (6; 10, 11) der Signalauswerteschaltung angeschlossen sind.

**4.** Positionsgeber nach Anspruch 3, dadurch gekennzeichnet, daß dem Differenzverstärker (6) eine die Amplitude der Signale vergleichende Schaltung und/oder eine die Phasenlage der Signale vergleichende Schaltung nachgeschaltet ist.

**5.** Positionsgeber nach einem der Ansprüche 1 bis 4, dadurch gekennzeichnet, daß unmittelbar neben jeder Elektrode (S) der ersten Gruppe auf einander gegenüberliegenden Seiten eine Elektrode (A -, B +) einer zweiten Gruppe bzw. einer vierten Gruppe angeordnet ist und daß unmittelbar neben der Elektrode.... (A - ) der zweiten Gruppe auf deren der Elektrode (S) der ersten Gruppe abgekehrten Seite eine Elektrode (B -) einer fünften Gruppe, sowie unmittelbar neben der Elektrode (B +) der vierten Gruppe auf deren der Elektrode (S) der ersten Gruppe abgekehrten Seite eine Elektrode (A +) einer dritten Gruppe angeordnet sind.

**6.** Positionsgeber nach einem der Ansprüche 1 bis 5, dadurch gekennzeichnet, daß den Elektroden (S) der ersten Gruppe und den mit diesen zusammenwirkenden Elektroden wenigstens eine auf O-Potential liegende Elekrode (∅) zugeordnet ist.

**7.** Positionsgeber nach Anspruch 6, dadurch gekennzeichnet, daß die auf O-Potential liegende Elektrode auf der Rückseite der die übrigen Elektroden tragenden Trägerplatte angeordnet ist.

**8.** Positionsgeber nach einem der Ansprüche 1 bis 7, dadurch gekennzeichnet, daß alle Elektroden (S, A -, A + , B -, B +, ∅) in einer Reihe nebeneinander angeordnet sind und daß alle Elektroden derselben Gruppe miteinander elekrisch leitend verbunden sind.

**9.** Positionsgeber nach einem der Ansprüche 1 bis 7, dadurch gekennzeichnet, daß alle Elektroden (S, A x -, A x +, B x -, B x +, A y -, A y +, B y -, B y +) in einer Matrix angeordnet sind, deren in der einen Richtung verlaufende, parallele Reihen die gleiche Elektrodenfolge haben wie die dazu rechtwinklig verlaufenden Reihen.

**10.** Positionsgeber nach Anspruch 9, dadurch gekennzeichnet, daß alle Reihen die gleiche Elektrodenfiguration aufweisen.

**11.** Positionsgeber nach einem der Ansprüche 8 bis 10, dadurch gekennzeichnet, daß die Ausgänge der beiden Differenzverstärker (10, 11), an welche die Eingänge der gleichgerichtete Reihen bildende Elektroden der zweiten und dritten Gruppe (A -, A +) bzw. der vierten und fünften Gruppe (B -, B +) angeschlossen sind, mit den Eingängen einer Richtungslogik (14, 15) verbunden sind.

**12.** Positionsgeber nach Anspruch 11, dadurch gekennzeichnet, daß für beide orthogonalen Richtungen der Matrix je zwei Differenzverstärker vorgesehen sind, wobei an die Eingänge der beiden Differenzverstärker der einen Richtung ebenso wie an diejenigen der anderen Richtung alle Elektroden der zweiten und dritten Gruppe bzw. der vierten und fünften Gruppe angeschlossen sind und daß beiden Differenzverstärkerpaaren je eine Richtungslogik nachgeschaltet ist.

**Claims**

**1.** Manually actuable position transducer with electrical output signals, having:

a) groups (S, A-, A +, B-, B +) of electrodes (S, A1-, A1 +, B1-, B1 +, Ax-, Ax +, Bx-, Bx +, Ay-, Ay +, By-, By +) which are disposed side by side, insulated from each other, and covered by an electrically-insulating layer (3) of which the side facing away from the electrodes has a bearing surface for a user's finger (4);

b) a voltage supply (5) to which all the electrodes (S) of a first group (S) are connected; and

c) a signal-evaluating circuit to which the electrodes of another group (A-, A +, B-, B +) are connected,

characterised in that

d) all the electrodes (S, A1-, A1 +, B1-, B1 +, Ax-, Ax +, Bx-, Bx +, Ay-, Ay +, By-, By +) are disposed side by side on one side of the electrically-insulating layer (3);

e) the electrodes (S, A1-, A1 +, B1-, B1 +, Ax-, Ax +, Bx-, Bx +, Ay-, Ay +, By-, By +) form at least three groups (S, A-, A +, B-, B +);

f) the voltage supply connected to the electrodes (S) of the first group (S) supplies an alternating voltage (Us);

g) the electrodes of the other groups (A-, A +, B-, B +) are connected to the signal-evaluating circuit which performs a signal comparison; and

h) beside each electrode (S) of the first group (S) is at least one electrode (A1 +, A1-; A1-, B1 +; A2-, B2 +; Ax +, Bx-; Ax-, Bx +; Ay-, By +; Ay-, By +) of the other groups (A-, A +, B-, B +).

2. Position transducer according to Claim 1, characterised in that the electrodes are formed by regions of a conductive layer on an electrically-insulating base plate (1).

3. Position transducer according to Claim 1 or Claim 2, characterised in that the two electrodes of a second and of a third group, respectively, which are spaced by the shortest distance from an electrode (S) of the first group disposed between them, are connected to respective inputs of a differential amplifier (6; 10, 11) of the signal-evaluating circuit.

4. Position transducer according to Claim 3, characterised in that the output of the differential amplifier (6) is connected to a circuit for comparing the amplitudes of signals and/or to a circuit for comparing the phase relationships of signals.

5. Position transducer according to one of Claims 1 to 4, characterised in that, immediately beside each electrode (S) of the first group, on opposite sides thereof, are an electrode (A-) of a second group and an electrode (B+) of a fourth group, and in that immediately beside the electrode (A-) of the second group, on the side thereof which faces away from the electrode (S) of the first group, is an electrode (B-) of a fifth group and immediately beside the electrode (B+) of the fourth group, on the side thereof which faces away from the electrode (S) of the first group, is an electrode (A+) of a third group.

6. Position transducer according to one of Claims 1 to 5, characterised in that at least one electrode (∅) which is at zero potential is disposed adjacent the electrodes (S) of the first group and the electrodes which cooperate therewith.

7. Position transducer according to Claim 6, characterised in that the electrode which is at zero potential is disposed on the reverse side of the base plate which carries the rest of the electrodes.

8. Position transducer according to one of Claims 1 to 7, characterised in that all the electrodes (S, A-, A+, B-, B+, ∅) are disposed beside each other in a row and in that all the electrodes of the same group are interconnected in an electrically-conductive manner.

9. Position transducer according to one of Claims 1 to 7, characterised in that all the electrodes (S, Ax-, Ax+, Bx-, Bx+, Ay-, Ay+, By-, By+) are arranged in a matrix, of which rows extending parallel to one axis have the same sequence of electrodes as rows extending at right angles thereto.

10. Position transducer according to Claim 9, characterised in that the configuration of the electrodes is the same in all the rows.

11. Position transducer according to one of Claims 8 to 10, characterised in that the outputs of the two differential amplifiers (10, 11), the inputs of which are connected respectively to the parallel rows of electrodes of the second and third groups (A-, A+) and to the parallel rows of electrodes of the fourth and fifth groups (B-, B+), are connected to the inputs of a direction logic circuit (14, 15).

12. Position transducer according to Claim 11, characterised in that two differential amplifiers are provided for each perpendicular axis of the matrix, whereby all the electrodes of the second and third groups and are connected to the inputs of the two differential amplifiers of one axis and all the electrodes of the fourth and fifth groups are connected to the inputs of the two differential amplifiers of the other axis, and in that the outputs of the two pairs of differential amplifiers are connected to respective direction logic circuits.

**Revendications**

1. Capteur de position se manipulant à la main et émettant des signaux électriques de sortie, comprenant

a) Des groupes (S, A-, A+, B-, B+) d'électrodes (S, A1-, A1+, B1-, B1+, Ax-, Ax+, Bx-, Bx+, Ay-, Ay+, By-, By+) disposées les unes à côté des autres et isolées les unes des autres, qui sont recouvertes d'une couche (3) isolante de l'électricité et dont le côté tourné à l'opposé des électrodes est prévu en surface d'appui pour un doigt (4) de l'utilisateur,

b) une source de tension (5) à laquelle toutes les électrodes (S) d'un premier groupe (S) sont connectées,

c) un circuit de dépouillement des signaux auquel les électrodes d'un autre groupe (A-, A+, B-, B+) sont connectées

caractérisé en ce que

d) toutes les électrodes (S, A1-, A1+, B1-, B1+, Ax-, Ax+, Bx-, Bx+, Ay-, Ay+, By-, By+) sont disposées les unes à côté des autres sur un côté de la couche (3) isolante de l'électricité,

e) les électrodes (S, A1-, A1 +, B1-, B1 +, Ax-, Ax +, Bx-, Bx +, Ay-, Ay +, By-, By +) forment au moins trois groupes (S, A-, A +, B-, B +)

f) la source de tension reliée aux électrodes (S) du premier groupe (S) délivre une tension alternative (Us),

g) les électrodes des autres groupes (A-, A +, B-, B +) sont connectées au circuit de dépouillement des signaux qui effectue une comparaison des signaux et

h) au moins une électrode (A1 +, A1- ; A1-, B1 +, A2-, B2 +, Ax +, Bx-, Ax-, Bx +, Ay-, By +, Ay-, By +) des autres groupes (A-, A +, B-, B +) est disposée à côté d'une électrode (S) du premier groupe (S).

2. Capteur de position selon la revendication 1, caractérisé en ce que les électrodes sont formées par des zones d'une couche conductrice d'un substrat (1) formé d'une plaque isolante de l'électricité.

3. Capteur de position selon la revendication 1 ou 2, caractérisé en ce que, dans chaque cas, les deux électrodes d'un second et d'un troisième groupes, qui sont à la plus petite distance d'une électrode (S) du premier groupe disposée entre elles, sont connectées à une, respectivement à l'autre entrée d'un amplificateur différentiel (6, 10, 11) du circuit de dépouillement des signaux.

4. Capteur de position selon la revendication 3, caractérisé en ce qu'un circuit comparateur de l'amplitude des signaux et/ou un circuit comparateur de la position de la phase des signaux est monté en aval de l'amplificateur différentiel (6).

5. Capteur de position selon l'une des revendications 1 à 4, caractérisé en ce qu'une électrode (A-, B +) d'un second groupe et, respectivement, d'un quatrième groupe est disposée sur les côtés opposés, immédiatement à côté de chaque électrode (S) du premier groupe et en ce qu'une électrode (B-) d'un cinquième groupe est disposée immédiatement à côté de l'électrode (A-) du second groupe, sur son côté tourné à l'opposé de l'électrode (S) du premier groupe et en ce qu'une électrode (A +) d'un troisième groupe est disposé immédiatement à côté de l'électrode (B +) du quatrième groupe, sur son côté tourné à l'opposé de l'électrode (S) du premier groupe.

6. Capteur de position selon l'une des revendications 1 à 5, caractérisé en ce qu'au moins une

électrode (∅) qui est à un potentiel O est affectée aux électrodes (S) du premier groupe et aux électrodes coopérant avec celles-ci.

7. Capteur de position selon la revendication 6, caractérisé en ce que l'électrode qui est au potentiel 0 est disposée au dos du substrat formé d'une plaque et supportant les autres électrodes.

8. Capteur de position selon l'une des revendications 1 à 7, caractérisé en ce que toutes les électrodes (S, A-, A +, B-, B +, ∅) sont disposées les unes à côté des autres en une rangée et en ce que toutes les électrodes du même groupe sont connectées électriquement les unes aux autres.

9. Capteur de position selon l'une des revendications 1 à 7, caractérisé en ce que toutes les électrodes (S, Ax-, Ax +, Bx-, Bx +, Ay-, Ay +, By-, By +) sont disposées en une matrice dont les rangées parallèles orientées dans une direction ont la même succession d'électrodes que celles des rangées qui leur sont perpendiculaires.

10. Capteur de position selon la revendication 9, caractérisé en ce que toutes les rangées ont la même configuration d'électrodes.

11. Capteur de position selon l'une des revendications 8 à 10, caractérisé en ce que les sorties des deux amplificateurs différentiels (10, 11), auxquels les entrées des électrodes des deuxième et troisième groupes (A-, A +) et respectivement des quatrième et cinquième groupes (B-, B +), qui forment des rangées orientées dans la même direction, sont connectées, sont reliées aux entrées d'une logique directionnelle (14, 15).

12. Capteur de position selon la revendication 11, caractérisé en ce que deux amplificateurs différentiels sont prévus pour chacune des deux directions orthogonales de la matrice, toutes les électrodes des second et troisième groupes et respectivement celles des quatrième et cinquième groupes étant connectées aux entrées des deux amplificateurs différentiels d'une direction ainsi qu'à celles de ceux de l'autre direction et en ce qu'une logique directionnelle est montée en aval des deux paires d'amplificateurs différentiels.

# Fig.1

# Fig.2

# Fig.3

Fig.4

Fig.5a

Fig.5b

Fig.5c

EP 0 299 204 B1

# Fig.6

ø    A1 + B1 + S    A1 − B1 −    ø    A2 + B2 + S    A2 −

# Fig.8

S    Ax+Bx+S    Ax−Bx−S    Ax+

Ay −
S
By+
Ay+
S
By −
Ay −
S

By +
Ay +

By −
Ay −

Ax+    Bx+    Ax−    Bx −

# Fig.7

EP 0 299 204 B1